Europäisches Patentamt

European Patent Office

Office européen des brevets

(19)

(11) **EP 0 999 622 A1**

(12) **DEMANDE DE BREVET EUROPEEN**

(43) Date de publication:
**10.05.2000  Bulletin 2000/19**

(51) Int Cl.⁷: **H01S 5/50**, H04B 10/17

(21) Numéro de dépôt: **99402715.9**

(22) Date de dépôt: **02.11.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité:  **05.11.1998  FR 9813949**

(71) Demandeur: **ALCATEL**
**75008 Paris (FR)**

(72) Inventeurs:
 • **Dorgeuille, Francois**
  **94230 Cachan (FR)**

 • **Lavigne, Bruno**
  **94230 Cachan (FR)**
 • **Chiaroni, Dominique**
  **94230 Cachan (FR)**
 • **Ougier, Christophe**
  **94230 Cachan (FR)**
 • **Emery, Jean-Yves**
  **94230 Cachan (FR)**

(74) Mandataire: **Ballot, Paul**
  **Cabinet Ballot-Schmit,**
  **16, Avenue du Pont Royal**
  **94230 Cachan (FR)**

(54) **Amplificateur optique à semi-conducteur à gain stabilisé réglable et système optique utilisant un tel amplificateur**

(57)    L'invention concerne un amplificateur optique à semi-conducteur comprenant un guide d'onde actif et une structure d'oscillateur laser encadrant le guide d'onde actif, caractérisé en ce qu'il comporte au moins une entrée de commande du gain au seuil de ladite structure laser pour permettre un réglage de la valeur du gain de l'amplificateur. Cet amplificateur est destiné à être utilisé dans un système optique qui comporte des moyens de régulation aptes à agir sur les entrées de commande de l'amplificateur, en réponse à la puissance optique de l'onde porteuse d'un signal de sortie afin de permettre un réglage de la valeur du gain de l'amplificateur. Ce système optique permet notamment de faire de l'égalisation en puissance d'un signal à l'entrée d'un système de télécommunications.

FIG.2A

EP 0 999 622 A1

13

P,λ

10

C

DP

—1—

P=P₀,λ

## FIG.2B

## Description

L'invention se situe dans le domaine des dispositifs photoniques ou optoélectroniques intégrés utilisables notamment pour la transmission de données numériques. Elle concerne plus particulièrement un amplificateur optique à semi-conducteur à gain stabilisé réglable, destiné à être utilisé dans un système optique pour réaliser une égalisation des niveaux de puissance moyenne transportée par les signaux qui le traversent.

Les lignes de transmission transportent aujourd'hui des signaux multiplexés en longueur d'onde. Dans un réseau de télécommunications on a, outre les fonctions de transmission, les fonctions de routage, de configuration ou de reconfiguration pour acheminer l'information d'un point donné d'entrée à un point donné de sortie du réseau. Les signaux ne suivent pas tous les mêmes trajets optiques. En particulier, ils peuvent subir des atténuations différentes. Par conséquent, à l'entrée d'un système optique de télécommunication, les signaux n'ont pas forcément tous le même niveau de puissance.

En général, les fonctions des systèmes de télécommunications optiques dépendent des conditions en entrée, c'est-à-dire notamment du niveau de puissance des signaux en entrée. La réponse en sortie de ces systèmes peut en effet varier selon les niveaux de puissance des signaux en entrée.

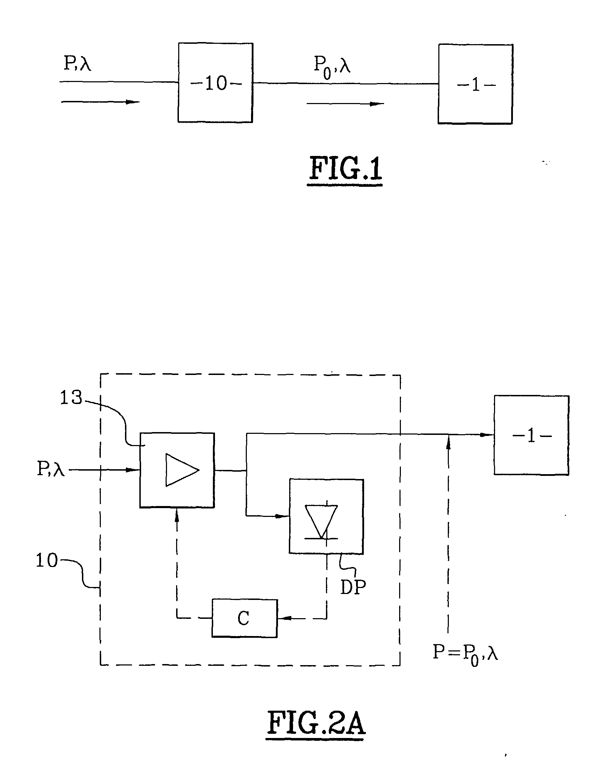

L'invention a donc pour but de réaliser un système optique ayant pour fonction d'égaliser les niveaux de puissance des signaux à l'entrée d'un système de télécommunications. Le schéma de la figure 1 permet de clarifier le but recherché. Le système optique, référencé 10, que l'on cherche à réaliser permettra de supprimer les variations de puissance P en entrée d'un autre système optique de télécommunication 1. Par ailleurs, la fonction que l'on cherche à réaliser doit être indépendante de la longueur d'onde du signal d'entrée l. La puissance Po en sortie du système optique 10 sera donc constante quelle que soit la puissance P du signal d'entrée et quelle que soit sa longueur d'onde l. Grâce à ce système optique 10, le signal pourra donc attaquer le système de télécommunication 1 dans les mêmes conditions, c'est-à-dire avec le même niveau de puissance quelle que soit la longueur d'onde en entrée.

Des solutions ont déjà été envisagées dans l'art antérieur pour effectuer une telle égalisation en puissance. Une première solution consiste à utiliser un amplificateur à fibre optique dopée Erbium, noté EDFA par la suite ("Erbium Doped Fiber Amplifier" en littérature anglo-saxonne), dans son régime de saturation. Pour le domaine de fréquences utilisées dans les télécommunications (supérieures à 100 MHz), le gain de l'amplificateur reste stable lorsque le signal passe d'un état haut à un état bas. L'EDFA réagit donc à la puissance moyenne du signal et il peut être utilisé dans son régime de saturation.

L'EDFA est couramment utilisé pour la transmission dans la fenêtre située autour de la longueur d'onde de 1,55 μm. Lorsqu'il fonctionne dans son régime de saturation, c'est-à-dire lorsque le niveau de puissance de l'onde porteuse d'un signal d'entrée est supérieur ou égal à la puissance de saturation de cet amplificateur, la puissance de l'onde porteuse du signal de sortie est constante.

Dans le cas de signaux $I_1$ à $I_N$ multiplexés en longueur d'onde, cet amplificateur ne sera sensible qu'à la puissance moyenne totale du signal reçu et non à la puissance moyenne de chaque canal. Par conséquent, il est nécessaire de démultiplexer le signal d'entrée et d'utiliser un EDFA pour traiter chaque canal. Or, un tel amplificateur coûte cher si bien qu'il n'est pas possible d'envisager l'utilisation d'un EDFA pour chaque canal, car le prix du système optique serait considérablement augmenté et deviendrait même inacceptable. De plus, un EDFA ne peut pas être intégré sur une puce.

Pour résoudre ces deux problèmes de coût et de compacité, une deuxième solution envisagée consiste à utiliser un amplificateur optique à semi-conducteur, noté "SOA" par la suite ("Semiconductor Optical Amplifier" en littérature anglo-saxonne), fonctionnant dans un régime linéaire. Les "SOAs" classiques possèdent un fort potentiel d'intégration. Dans le régime de saturation de l'amplificateur, le gain varie en fonction des données binaires modulant le signal amplifié, malgré la modulation très élevée généralement utilisée dans le domaine des télécommunications. Cette non-linéarité du gain provoque une réduction de contraste entre le niveau haut et le niveau bas du signal amplifié. Dans ce régime, le SOA est sensible à la puissance instantanée du signal. Il doit donc être utilisé dans son régime linéaire pour éviter toute déformation du signal de sortie. La puissance de l'onde porteuse des signaux d'entrée doit donc être très inférieure à sa puissance de saturation.

D'autre part, pour permettre une égalisation en puissance, le gain de l'amplificateur doit pouvoir être réglé. Pour cela, le gain de l'amplificateur est donc asservi à la puissance de sortie. Un mode de réalisation d'un tel asservissement est schématisé sur la figure 2A. Une photodiode DP mesure la puissance émise par l'onde porteuse du signal en sortie du SOA 13, puis un circuit de traitement électronique C compare la valeur de la puissance mesurée P à une valeur de consigne Po et déclenche un signal de commande qui agit sur le courant d'amplification du SOA 13 et donc sur son gain, pour pouvoir égaliser la valeur mesurée à la valeur de consigne. Le système à contre-réaction électronique permet donc de contrôler et d'ajuster le gain de l'amplificateur.

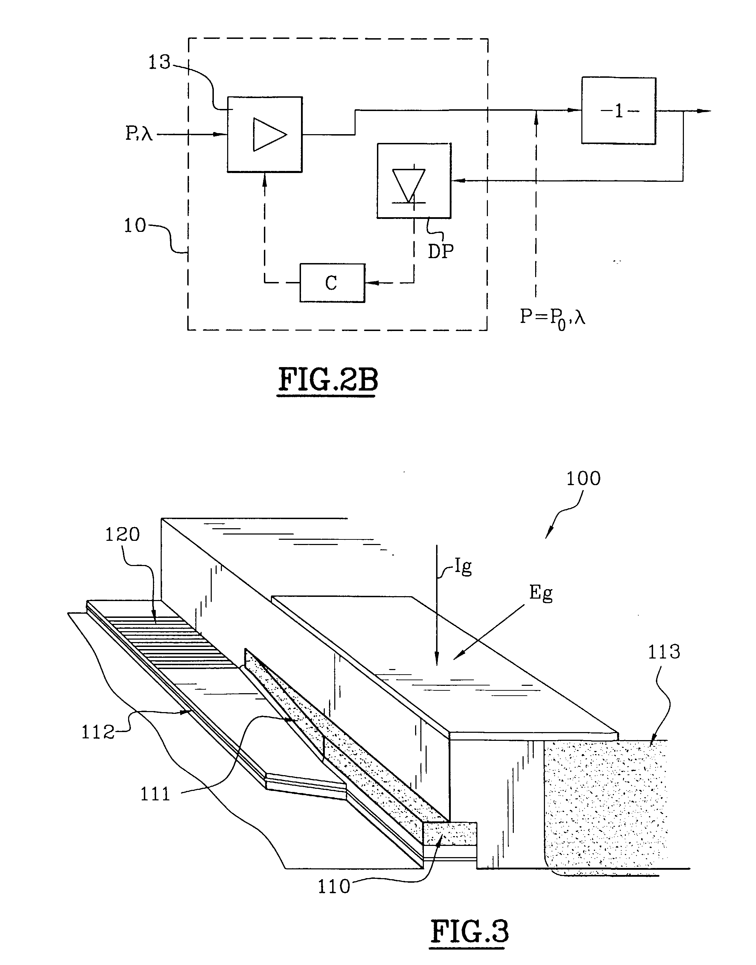

La figure 2B décrit un second mode de réalisation de cet asservissement. Dans cette variante, le gain de l'amplificateur n'est plus asservi sur sa puissance de sortie, mais sur la puissance détectée à la sortie du système de télécommunications 1.

L'inconvénient majeur de cette solution réside dans le fait que la puissance optique disponible en sortie du dispositif 10 reste faible. La puissance de saturation est définie comme étant la valeur de la puissance existante lorsque le gain chute de la moitié de sa valeur. Par conséquent, l'utilisation du SOA dans son régime linéaire, est très limitée et la puissance P du signal en entrée doit être très faible pour ne pas dépasser la puissance de saturation.

Pour palier cet inconvénient de faible linéarité et pour augmenter la puissance de saturation du SOA, une solution consiste à utiliser un amplificateur optique à semi-conducteur à gain stabilisé, noté GC-SOA par la suite ("Gain-Clamped Semiconductor Optical Amplifier" en littérature anglo-saxonne).

La figure 3 représente un schéma en perspective représentant un mode de réalisation d'un amplificateur à gain stabilisé GC-SOA 100 avec arrachement, montrant les couches en formation en cours de fabrication. Cet amplificateur étant symétrique, seule une moitié est représentée sur ce schéma. Cet amplificateur comporte un guide d'onde actif 110 gravé sous forme de ruban et enterré dans une couche de gaine localement implantée en protons 113. Un adaptateur de mode 111 est -placé à chaque extrémité du guide d'onde actif 110. Le guide actif 110 est disposé au-dessus d'un guide d'onde passif 112. Le couplage entre ces deux guides est donc vertical et évanescent. De plus, deux réflecteurs de Bragg 120, échantillonnés ou non, sont disposés de part et d'autre du guide actif 110, de manière à créer une cavité laser autour du milieu amplificateur. Une électrode Eg est par ailleurs prévue pour permettre d'injecter un courant d'amplification Ig nécessaire pour produire le gain dans le milieu amplificateur.

Pour stabiliser le gain de cet amplificateur GC-SOA, on utilise la réaction optique produite par les réflecteurs de Bragg à la longueur d'onde $l_B$. Le gain dans le milieu amplificateur augmente avec le courant Ig, jusqu'à ce qu'il atteigne une valeur seuil, pour laquelle l'oscillation laser se produit. On est alors en présence d'un fonctionnement en oscillateur laser. Le fonctionnement d'un oscillateur laser est tel que tant que l'on se trouve au-dessus du seuil de ce laser, le gain de la cavité reste constant. Le gain de l'amplificateur est donc stabilisé. L'oscillation laser se produit à une longueur d'onde $l_B$ non utilisée pour l'amplification du signal d'entrée. Cette longueur d'onde d'oscillation $l_B$ est ensuite éliminée par filtrage.

Dans un autre mode de réalisation de cet amplificateur à gain stabilisé GC-SOA, cette réaction optique est obtenue entre un réflecteur de Bragg, échantillonné ou non, et une facette clivée opposée au réflecteur.

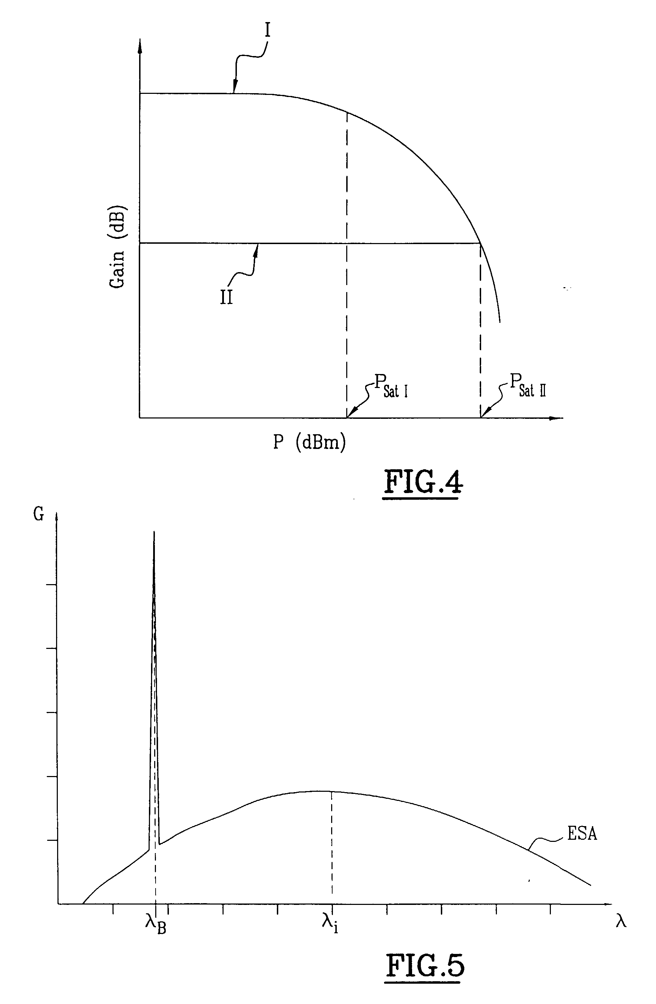

Dès que le seuil d'oscillation laser est atteint, le gain de l'amplificateur est fixé et stabilisé. La figure 4 représente deux courbes I et II du gain en fonction de la puissance P du signal de sortie, respectivement dans un SOA classique et dans un amplificateur à gain stabilisé GC-SOA, pour un courant injecté identique. Ces deux courbes mettent en évidence l'augmentation de la linéarité de la réponse optique, pour un amplificateur à gain stabilisé. La puissance de saturation $P_{satII}$ du GC-SOA est donc augmentée par rapport à la puissance de saturation $P_{satI}$ d'un SOA.

Cependant, un amplificateur à gain stabilisé ne permet pas de remplacer directement un SOA classique, dans la fonction d'égalisation en puissance telle qu'elle est décrite sur la figure 2. En effet, dans ce cas, le gain de l'amplificateur étant constant en sortie, il ne dépend plus du courant d'amplification Ig. La contre-réaction électronique n'a donc plus d'effet et ne permet plus d'ajuster le gain de l'amplificateur. Par conséquent, la puissance en sortie de l'amplificateur suit les variations de la puissance d'entrée. Or, comme il a été décrit précédemment, on cherche à réaliser une égalisation en puissance pour que la puissance en sortie de l'amplificateur soit constante quel que soit le niveau de la puissance du signal d'entrée.

L'invention permet de résoudre les inconvénients des dispositifs de l'art antérieur. Elle propose pour cela un amplificateur optique à semi-conducteur à gain stabilisé et réglable. Cet amplificateur présente l'avantage d'avoir une puissance de saturation relativement élevée, d'être intégrable, et de présenter un gain stabilisé dont la valeur peut être réglée. Cet amplificateur est par ailleurs destiné à être utilisé dans un système optique apte à réaliser de l'égalisation en puissance.

L'invention se rapporte plus particulièrement à un amplificateur optique à semi-conducteur comprenant un guide d'onde actif et une structure d'oscillateur laser encadrant le guide d'onde actif, caractérisé en ce qu'il comporte au moins une entrée de commande du gain au seuil de ladite structure laser pour permettre un réglage de la valeur du gain de l'amplificateur.

Selon une autre caractéristique de l'invention, l' (les) entrée(s) de commande est (sont) constituée(s) par au moins une électrode de commande qui est disposée au-dessus d'au moins une section du guide d'onde actif.

Selon une autre caractéristique de l'invention, l'amplificateur comprend en outre un guide d'onde passif, qui est couplé verticalement avec le guide d'onde actif, et 1' (les) entrée(s) de commande est (sont) constituée(s) par au moins une électrode disposée au-dessus d'au moins une section du guide d'onde passif.

Selon une autre caractéristique de l'invention, l' (les) entrée(s) de commande est (sont) constituée(s) par deux électrodes de commande qui sont disposées au-dessus de deux réflecteurs de Bragg de la structure laser. Ces deux électrodes de commande peuvent en outre être reliées entre elles de façon à injecter simultanément un courant identique dans chacun de ces deux réflecteurs.

Selon une autre caractéristique de l'invention, la structure laser comporte deux réflecteurs dont au moins un est échantillonné, ou présente un déphasage, et l'(les) entrée(s) de commande est (sont) constituée

(s) par au moins une électrode de commande qui est disposée au-dessus d'au moins un réflecteur.

Selon une autre caractéristique de l'invention, la structure laser comporte un seul réflecteur de Bragg, échantillonné ou non, et l'(les) entrée(s) de commande est (sont) constituée(s) par au moins une électrode de commande qui est disposée au-dessus du réflecteur de Bragg.

Un autre objet de l'invention concerne un système optique comprenant un amplificateur, apte à délivrer une puissance optique de l'onde porteuse d'un signal de sortie constante quel que soit le niveau de puissance d'un signal en entrée. L'amplificateur comporte une structure laser de stabilisation de gain et au moins une entrée de commande du gain au seuil de ladite structure laser, et ledit système optique comporte en outre des moyens de régulation destinés à agir sur les entrées de commande de l'amplificateur, en réponse à la puissance optique de l'onde porteuse du signal de sortie afin de permettre un réglage de la valeur du gain de l'amplificateur.

Grâce à l'amplificateur selon l'invention et au système optique, les fluctuations en puissance d'un signal peuvent être supprimées. L'amplificateur selon l'invention peut être utilisé dans des fenêtres centrées autour de n'importe quelle longueur d'onde située entre 1,2 μm et 1,6 μm. Il est simple, peu coûteux et intégrable.

D'autres particularités et avantages de l'invention apparaîtront à la lecture de la description donnée à titre d'exemple illustratif mais non limitatif et faite en référence aux figures annexées qui représentent :

- la figure 1, déjà décrite, un schéma de principe d'un système optique destiné à égaliser les niveaux de puissance d'un signal en entrée d'un système de télécommunications,
- les figures 2A et 2B, déjà décrites, deux schémas plus détaillés de deux modes de réalisation d'un système optique existant, comprenant une boucle d'asservissement, pour réaliser une égalisation en puissance,
- la figure 3, déjà décrite, un schéma en perspective d'un amplificateur à gain stabilisé avec arrachement montrant les couches en formation en cours de fabrication,
- la figure 4, déjà décrite, deux courbes I et II de gain en fonction de la puissance de sortie, respectivement d'un amplificateur SOA classique et d'un amplificateur à gain stabilisé GC-SOA classique, pour un courant injecté identique,
- la figure 5, une courbe de gain en fonction de la longueur d'onde dans un amplificateur à gain stabilisé GC-SOA,
- la figure 6, une vue de dessus d'un amplificateur selon un premier mode de réalisation de l'invention, avec un schéma de la position des électrodes,
- la figure 7, un schéma en coupe longitudinale d'un autre amplificateur selon le premier mode de réalisation de l'invention,
- la figure 8, des courbes A, B et C du gain de l'amplificateur selon l'invention, en fonction de la puissance du signal en sortie de l'amplificateur,
- la figure 9, des courbes de gain en fonction de la longueur d'onde correspondant à un amplificateur selon un deuxième mode de réalisation,
- la figure 10, un schéma d'une vue en coupe longitudinale d'un amplificateur selon un deuxième mode de réalisation.

La figure 5 représente la raie d'oscillation laser, émise à la longueur d'onde $I_B$, de la structure laser de l'amplificateur selon l'invention, et l'Emission Spontanée Amplifiée (ESA) qui est répartie dans toute la bande passante de cet amplificateur. La fenêtre d'amplification doit être centrée autour d'une longueur d'onde $I_i$ différente de la longueur d'onde $I_B$ d'oscillation laser, de manière à permettre de séparer facilement par filtrage le signal amplifié de l'oscillation laser.

Pour qu'une cavité laser puisse osciller, il faut que la condition suivante soit remplie :

$$G(I_B) \times a(I_B) \times R(I_B) = 1,$$

où

$G(I_B)$ représente le gain du milieu amplificateur à la longueur d'onde $I_B$ de l'oscillation laser,
$a(I_B)$ représente les pertes par absorption de la cavité laser à la longueur d'onde $I_B$, et
$R(I_B)$ représente les pertes de ré-alimentation optique dans la cavité laser à la longueur d'onde $I_B$. La valeur du gain du milieu amplificateur qui vérifie cette relation est la valeur qui permet de compenser les pertes totales dans la cavité laser. C'est le gain au seuil $G_{th}(I_B)$ du laser.

L'invention exploite cette condition et propose d'agir sur le gain au seuil $G_{th}(I_B)$ de la cavité laser pour le faire varier et permettre un réglage de la valeur du gain de l'amplificateur G(I).

Deux modes de réalisation préférés pour effectuer un amplificateur à gain stabilisé réglable sont décrits dans ce qui suit. Ces deux modes de réalisation sont basés sur le fait que la valeur du gain au seuil de la cavité laser peut être modifiée en agissant soit sur les propriétés du milieu amplificateur ; soit sur les propriétés des réflecteurs de Bragg situés de part et d'autre du milieu amplificateur et formant la cavité laser. Bien entendu, ces deux effets peuvent être combinés.

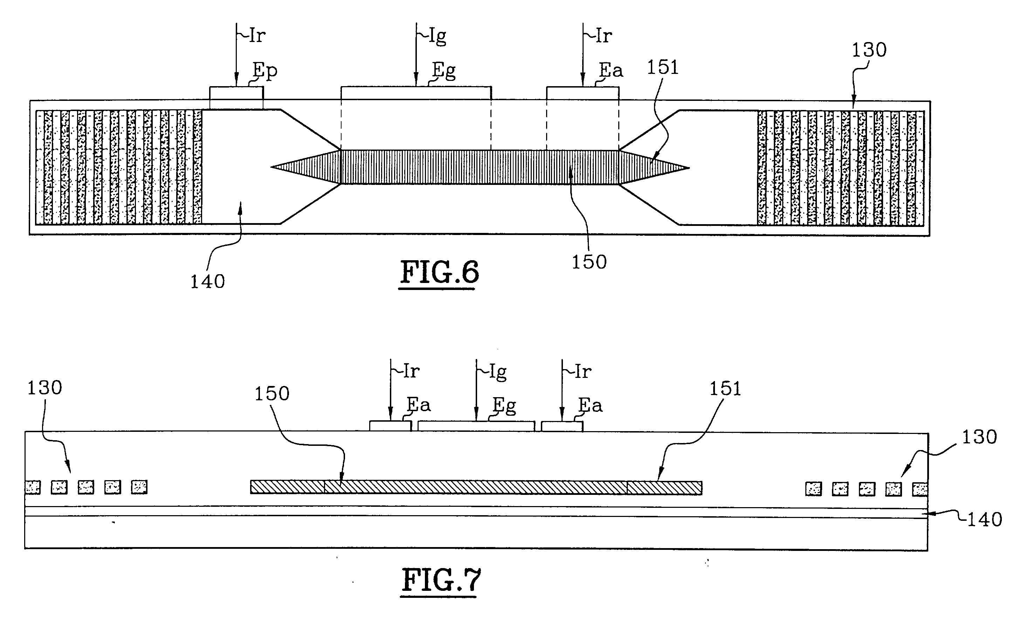

Les figures 6 et 7 représentent respectivement une vue de dessus et une vue en coupe longitudinale d'un amplificateur selon un premier mode de réalisation de l'invention. Sur la figure 6, sont également schématisés les emplacements de certaines électrodes par rapport aux guides d'onde actif et passif et aux réflecteurs de Bragg de l'amplificateur.

Tout comme dans un amplificateur à gain stabilisé classique, l'amplificateur selon l'invention comporte un guide d'onde actif 150 aux extrémités duquel sont prévus des adaptateurs de mode 151. Ce guide actif est couplé verticalement avec un guide passif 140. Deux réflecteurs de Bragg 130, échantillonnés ou non, sont disposés de part et d'autre du guide actif 150, 151 pour créer une cavité laser.

Dans une variante de réalisation, la cavité laser peut également être créée par un réflecteur de Bragg, échantillonné ou non, et une facette clivée opposée au réflecteur.

La structure de cet amplificateur diffère de celle des amplificateurs à gain stabilisé classiques par le fait qu'elle comporte au moins une entrée de commande permettant d'agir sur le gain au seuil de la cavité laser et de le faire varier. Cette (ou ces) entrée(s) de commande est (sont) constituée(s) par au moins une électrode supplémentaire qui est disposée au-dessus d'au moins une section d'un des guides d'onde. Ainsi, par exemple, l'amplificateur comporte au moins une électrode de commande Ea disposée au-dessus d'au moins une section du guide actif 150 (figures 6 et 7) et/ou au moins une électrode de commande Ep disposée au-dessus d'au moins une section du guide passif 140 (figure 6).

Le guide d'onde actif 150, 151 de l'amplificateur est généralement réalisé en matériau quaternaire. Ce matériau est absorbant pour les longueurs d'onde telles que l<lg, lorsqu'aucun porteur n'y est injecté. lg est la largeur de bande interdite du matériau quaternaire, exprimé dans l'échelle des longueurs d'onde. Son atténuation diminue au fur et à mesure que le courant d'amplification Ig injecté dans le guide augmente, c'est-à-dire au fur et à mesure que la densité des porteurs augmente. A partir d'une certaine valeur du courant injecté, le guide devient amplificateur et présente un gain. Cette propriété du guide d'onde, qui peut être soit absorbant soit amplificateur selon les conditions de fonctionnement, est utilisée dans ce premier mode de réalisation de l'amplificateur selon l'invention.

Dans ce cas, on considère en effet que chaque section de guide d'onde, qui est recouverte par une électrode de commande Ea et/ou Ep, est absorbante et présente une atténuation a. En revanche, les autres sections de guide d'onde actif constituent le milieu amplificateur du composant de l'invention et présentent donc un gain G. On rappelle que la relation fixant les conditions de l'oscillation laser est telle que:

$$G(l_B) \times a(l_B) \times R(l_B) = 1,$$ la longueur d'onde $l_B$ de l'oscillation laser étant fixe.

Pour pouvoir modifier les propriétés de la cavité laser, et notamment son gain au seuil $G_{th}(l_B)$, il est possible de faire varier les pertes $a(l_B)$ de la cavité laser en injectant un (ou plusieurs) courant(s) de contre-réaction $i_r$ sur une (ou plusieurs) électrode de commande Ep et/ou Ea. En modifiant le gain au seuil $G_{th}(l_B)$ de la cavité laser, on peut accorder le gain du milieu amplificateur G(l) à la longueur d'onde 1 du signal. L'accordabilité obtenue, c'est à dire la gamme de réglage, peut être supérieure à 10dB. Ce résultat est significatif.

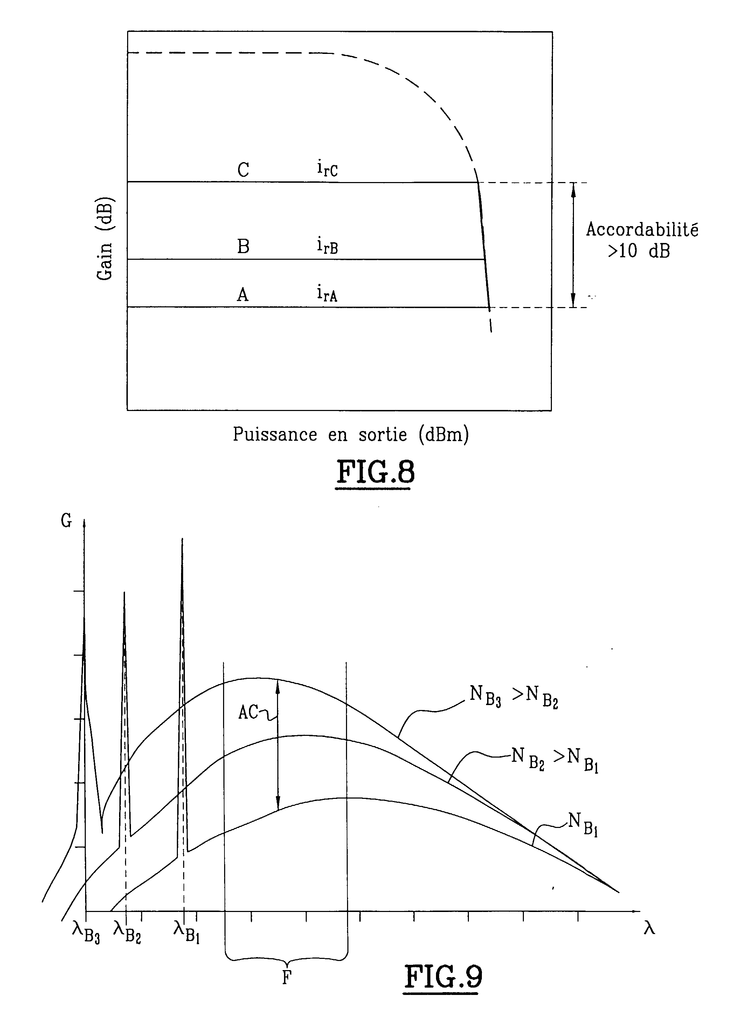

La figure 8 illustre trois courbes correspondantes A, B et C du gain G stabilisé et réglable de l'amplificateur en fonction de la puissance de l'onde porteuse du signal de sortie. Ces courbes confirment que, quelle que soit la puissance à l'entrée, le gain G de l'amplificateur est stabilisé et peut être réglé sur différentes valeurs en injectant un courant de contre-réaction $i_r$ sur au moins une électrode de commande Ea et/ou Ep.

Dans une variante de ce mode de réalisation, il est également envisageable d'appliquer, sur une ou plusieurs électrodes de commande Ea et/ou Ep, une tension polarisée en inverse. Dans ce cas, on obtient une section de guide qui fonctionne comme un modulateur électro-absorbant.

Dans une autre variante, on pourra en outre appliquer simultanément un courant sur une ou plusieurs électrodes de commande, et une tension négative sur une ou plusieurs autres électrodes de commande, afin de modifier les propriétés de la cavité laser.

Selon un deuxième mode de réalisation de l'amplificateur selon l'invention, on agit sur le coefficient de réflection R de façon à modifier les pertes de ré-alimentation optique dans la cavité laser. Dans ce cas, plusieurs variantes sont possibles. Dans une première variante, la structure laser comporte deux réflecteurs de Bragg, dont au moins un est échantillonné et bien connu de l'homme de l'art. Au moins un de ces réflecteurs de Bragg peut également présenter un déphasage; on dit que c'est une superstructure qui est aussi bien connue de l'homme de l'art. Dans cette variante, l'amplificateur comporte au moins une entrée de commande constituée par au moins une électrode de commande qui est disposée au-dessus d'au moins un des réflecteurs.

Dans une deuxième variante, la structure laser comporte un seul réflecteur de Bragg, échantillonné ou non, disposé à l'opposé d'une facette clivée. Dans cette variante, l'amplificateur comporte au moins une entrée de commande constituée par au moins une électrode de commande qui est disposée au-dessus du réflecteur de Bragg.

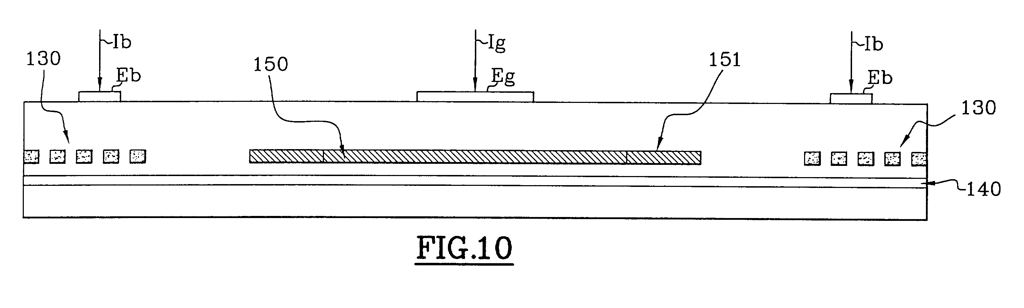

Dans une troisième variante, la structure laser comporte deux réflecteurs de Bragg non échantillonnés 130. C'est cette variante qui est illustrée sur le schéma d'une vue en coupe longitudinale de la figure 10, sur laquelle les mêmes références ont été utilisées pour désigner les mêmes éléments que sur les figures 6 et 7. Dans ce cas, l'amplificateur selon l'invention comporte deux électrodes de commande Eb qui sont disposées au-dessus de chaque réflecteur de Bragg 130 de la cavité laser. Les amplificateurs selon les trois variantes précitées fonctionnent de manière identique. Seul le nombre d'électrodes de commande peut changer. C'est pourquoi, seul le fonctionnement de l'amplificateur selon la troisième variante à été détaillée dans ce qui suit.

L'injection de porteurs dans ces réflecteurs, par l'intermédiaire des électrodes de commande Eb, permet de faire varier simultanément l'absorption dans le réflecteur de Bragg, donc sa réflectivité, et de déplacer la longueur d'onde de Bragg $l_B$. Ce résultat est schématisé par la figure 9 qui représente plusieurs courbes de gain G de l'amplificateur en fonction de la longueur d'onde l, selon la densité de porteurs $N_{B1}$, $N_{B2}$, $N_{B3}$ injectés dans les réflecteurs de Bragg. Au fur et à mesure que le courant injecté sur les électrodes de commande Eb augmente, c'est-à-dire lorsque la densité de porteurs injectés augmente, la longueur d'onde de Bragg $l_B$ se déplace ($l_{B1}$, $l_{B2}$ ...). Pour que la condition d'oscillation laser soit maintenue à la nouvelle longueur d'onde de Bragg $l_{B2}$, la courbe de gain de l'amplificateur est modifiée.

Dans une autre variante de réalisation, on peut également relier les deux électrodes Eb, par un fil conducteur ou autre, afin d'injecter simultanément un courant identique dans les deux réflecteurs.

Pour déplacer la longueur d'onde d'oscillation laser $l_B$ de la cavité laser, on réalise par exemple une injection de courant de contre-réaction Ib sur les électrodes de commande Eb. Une injection de courant sur une seule électrode de commande suffit dans le cas des amplificateurs qui comprennent au moins un réflecteur échantillonné. Cette injection de porteurs permet de modifier l'indice optique dans les réflecteurs de Bragg. La modification de l'indice optique dans un réflecteur est une façon de faire varier son pas et donc de modifier les caractéristiques de la cavité laser, et notamment le gain au seuil à partir duquel la cavité laser oscille, et la longueur d'onde d'oscillation laser.

En faisant varier la longueur d'onde $l_B$ de l'oscillation laser de la cavité, de $l_{B1}$ vers $l_{B3}$, comme schématisé sur la figure 9, on obtient une série de courbes de gain dont l'intensité augmente avec la densité de porteurs injectés $N_{B1}$, $N_{B2}$, $N_{B3}$ (avec $N_{B3} > N_{B2} > N_{B1}$). L'accordabilité du gain de l'amplificateur, dans une fenêtre spectrale F, centrée autour de 1,55$\mu$m par exemple, est schématisée par la double flèche AC sur la figure 9. L'accordabilité obtenue est significative; elle peut être supérieure à 10 dB.

Dans une variante de réalisation, on peut également appliquer, sur l'électrode de commande Eb, une tension négative. Dans ce cas, on obtient un effet électro-réfractif.

L'invention se rapporte en outre à un système optique destiné à être placé à l'entrée d'un système de télécommunications, afin d'égaliser les niveaux de puissance des signaux à l'entrée de ce système de télécommunications. La structure du système optique selon l'invention correspond aux schémas des systèmes des figures 2A et 2B car on utilise la même boucle d'asservissement pour rétroagir sur l'amplificateur. Seul l'amplificateur utilisé dans le système selon l'invention change. En effet, l'amplificateur optique utilisé est l'amplificateur à semi-conducteur à gain stabilisé réglable selon l'invention. Un filtre est en outre disposé à la sortie de cet amplificateur pour séparer la longueur d'onde d'oscillation $l_B$ du signal amplifié.

Tout comme dans l'art antérieur, la boucle d'asservissement comprend des moyens de régulation. Ces moyens de régulation sont constitués par une photodiode, apte à mesurer la puissance de l'onde porteuse du signal en sortie de l'amplificateur (ou, dans une variante, en sortie du système de télécommunications), et par un circuit de traitement électronique. Ce circuit comporte, quant à lui, d'une part un comparateur pour comparer la valeur de la puissance mesurée à une valeur de consigne, et d'autre part une interface apte à déclencher un signal de commande qui est appliqué sur au moins une électrode de commande de l'amplificateur pour réajuster le niveau du gain de l'amplificateur afin d'avoir un niveau de puissance constant en sortie.

Grâce à l'amplificateur à gain stabilisé réglable selon l'invention il est possible de supprimer les fluctuations de puissance d'un signal à l'entrée d'un système de télécommunications. Le gain de l'amplificateur est réglable sur une gamme supérieure à 10 dB. L'amplificateur est utilisé pour réaliser une égalisation en puissance dans des fenêtres centrées autour de n'importe quelle longueur d'onde située entre 1,2$\mu$m ou de 1,6$\mu$m qui sont les longueurs d'onde généralement utilisées dans les télécommunications optiques. D'autre part, l'amplificateur selon l'invention présente l'avantage d'être peu encombrant car il est intégré sur une puce.

## Revendications

**1.** Amplificateur optique à semi-conducteur comprenant un guide d'onde actif (150) et une structure d'oscillateur laser encadrant le guide d'onde actif, caractérisé en ce qu'il comporte au moins une entrée de commande (Ea, Ep, Eb) du gain au seuil de ladite structure laser pour permettre un réglage de la valeur du gain de l'amplificateur.

**2.** Amplificateur selon la revendication 1, caractérisé en ce que l' (les) entrée(s) de commande est (sont) constituée(s) par au moins une électrode de commande (Ea) qui est disposée au-dessus d'au moins une section du guide d'onde actif (150).

**3.** Amplificateur selon l'une des revendications 1 à 2, caractérisé en ce qu'il comprend en outre un guide d'onde passif (140) couplé verticalement avec le guide d'onde actif (150), et en ce que l' (les) entrée (s) de commande est (sont) constituée (s) par au moins une électrode de commande (Ep) qui est disposée au dessus d'au moins une section de ce guide d'onde passif (140).

**4.** Amplificateur selon la revendication 1, caractérisé en ce que l' (les) entrée(s) de commande est (sont) constituée(s) par deux électrodes de commande (Eb) qui sont disposées au-dessus de deux réflecteurs de Bragg constitutifs de la structure laser.

5. Amplificateur selon la revendication 4, caractérisé en ce que les deux électrodes de commande (Eb) sont reliées de façon à injecter simultanément un courant identique dans chaque réflecteur.

6. Amplificateur selon la revendication 1, caractérisé en ce que la structure laser comporte deux réflecteurs dont au moins un est échantillonné, ou présente un déphasage, et l'(les) entrée(s) de commande est (sont) constituée(s) par au moins une électrode de commande qui est disposée au-dessus d'au moins un réflecteur.

7. Amplificateur selon la revendication 1, caractérisé en ce que la structure laser comporte un seul réflecteur de Bragg, échantillonné ou non, et l'(les) entrée(s) de commande est (sont) constituée(s) par au moins une électrode de commande qui est disposée au dessus du réflecteur de bragg.

8. Système optique comprenant un amplificateur optique à semi-conducteur, apte à délivrer une puissance optique de l'onde porteuse d'un signal de sortie constante quels que soient les niveaux de puissance (P) d'un signal en entrée, caractérisé en ce que l'amplificateur comporte une structure d'oscillateur laser de stabilisation de gain et au moins une entrée de commande du gain au seuil de ladite structure laser, et en ce que ledit système de transmission comporte en outre des moyens de régulation destinés à agir sur les entrées de commande de l'amplificateur, en réponse à la puissance optique de l'onde porteuse du signal de sortie afin de permettre un réglage de la valeur du gain de l'amplificateur.

P,λ     —10—     $P_0$,λ     —1—

## FIG.1

13

P,λ

10

DP

C

P=$P_0$,λ

## FIG.2A

## FIG.2B

$P,\lambda$

$P=P_0,\lambda$

DP

C

## FIG.3

Ig

Eg

100

120

112

111

113

110

I

Gain (dB)

II

P$_{Sat\ I}$    P$_{Sat\ II}$

P (dBm)

## FIG.4

G

ESA

λ$_B$    λ$_i$    λ

## FIG.5

FIG.6

FIG.7

FIG.8

FIG.9

FIG.10

**Office européen des brevets**

**RAPPORT DE RECHERCHE EUROPEENNE**

Numéro de la demande

EP 99 40 2715

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | YASAKA H ET AL: "BROAD-RANGE TUNABLE WAVELENGTH CONVERSION OF HIGH-BIT-RATE SIGNALS USING SUPER STRUCTURE GRATING DISTRIBUTED BRAGG REFLECTOR LASERS" IEEE JOURNAL OF QUANTUM ELECTRONICS, vol. 32, no. 3, 1 mars 1996 (1996-03-01), pages 463-470, XP000581028 ISSN: 0018-9197 | 1-6 | H01S5/50 H04B10/17 |
| A | * page 463 - page 464; figure 1 * | 7,8 | |
| X | EP 0 174 729 A (BRITISH TELECOMM) 19 mars 1986 (1986-03-19) * page 3, ligne 28 - page 4, ligne 19; revendication 6; figures 3,4 * * page 10, ligne 21-31 * | 1,2,8 | |
| A | DOUSSIERE P ET AL: "CLAMPED GAIN TRAVELLING WAVE SEMICONDUCTOR OPTICAL AMPLIFIER FOR WAVELENGTH DIVISION MULTIPLEXING APPLICATIONS" PROCEEDINGS OF THE INTERNATIONAL SEMICONDUCTOR LASER CONFERENCE, MAUI, HAWAII, SEPT. 19 - 23, 1994, no. CONF. 14, 19 septembre 1994 (1994-09-19), page 185/186 XP000514864 INSTITUTE OF ELECTRICAL AND ELECTRONICS ENGINEERS ISBN: 0-7803-1755-6 * le document en entier * | 1-8 | DOMAINES TECHNIQUES RECHERCHES (Int.Cl.7) H01S |
| A | EP 0 639 876 A (ALCATEL NV) 22 février 1995 (1995-02-22) * le document en entier * | 1,8 | |

-/--

Le présent rapport a été établi pour toutes les revendications

| Lieu de la recherche | Date d'achèvement de la recherche | Examinateur |
|---|---|---|
| LA HAYE | 15 février 2000 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Office européen
des brevets **RAPPORT DE RECHERCHE EUROPEENNE**

Numéro de la demande

EP 99 40 2715

## DOCUMENTS CONSIDERES COMME PERTINENTS

| Catégorie | Citation du document avec Indication, en cas de besoin, des parties pertinentes | Revendication concernée | CLASSEMENT DE LA DEMANDE (Int.Cl.7) |
|---|---|---|---|
| A | PATENT ABSTRACTS OF JAPAN<br>vol. 016, no. 540 (P-1450),<br>10 novembre 1992 (1992-11-10)<br>& JP 04 204719 A (HITACHI LTD),<br>27 juillet 1992 (1992-07-27)<br>* abrégé * | 1,8 | |
| A | PATENT ABSTRACTS OF JAPAN<br>vol. 017, no. 235 (P-1533),<br>12 mai 1993 (1993-05-12)<br>& JP 04 362617 A (NEC CORP),<br>15 décembre 1992 (1992-12-15)<br>* abrégé * | 1,8 | |

**DOMAINES TECHNIQUES RECHERCHES (Int.Cl.7)**

Le présent rapport a été établi pour toutes les revendications

| Lieu de la recherche | Date d'achèvement de la recherche | Examinateur |
|---|---|---|
| LA HAYE | 15 février 2000 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

16

**ANNEXE AU RAPPORT DE RECHERCHE EUROPEENNE
RELATIF A LA DEMANDE DE BREVET EUROPEEN NO.**    EP 99 40 2715

La présente annexe Indique les membres de la famille de brevets relatifs aux documents brevets cités dans le rapport de recherche européenne visé cl–dessus.
Lesdlts members sont contenus au fichier Informatique de l'Office européen des brevets à la date du
Les renseignements foumis sont donnés à titre indicatif et n'engagent pas la responsabilité de l'Office européen des brevets.

15-02-2000

| Document brevet cité au rapport de recherche | | Date de publication | Membre(s) de la famille de brevet(s) | | Date de publication |
|---|---|---|---|---|---|
| EP 0174729 | A | 19-03-1986 | AT | 39396 T | 15-01-1989 |
| | | | CA | 1251845 A | 28-03-1989 |
| | | | DE | 3566937 A | 26-01-1989 |
| | | | JP | 2018663 C | 19-02-1996 |
| | | | JP | 7032276 B | 10-04-1995 |
| | | | JP | 61105887 A | 23-05-1986 |
| | | | US | 4736164 A | 05-04-1988 |
| EP 0639876 | A | 22-02-1995 | FR | 2709189 A | 24-02-1995 |
| | | | JP | 7106714 A | 21-04-1995 |
| JP 04204719 | A | 27-07-1992 | JP | 2934500 B | 16-08-1999 |
| JP 04362617 | A | 15-12-1992 | AUCUN | | |

EPO FORM P0460

Pour tout renseignement concernant cette annexe : voir Journal Officiel de l'Office européen des brevets, No.12/82